# EUROPEAN PATENT APPLICATION

(11) **EP 4 535 943 A2**
(43) Date of publication of application: **09.04.2025**
(21) Application number: 24201495.9
(22) Date of filing: 19.09.2024
(51) Int. Cl.: H05K 7/14

(54) **HIGH DENSITY POWER DISTRIBUTION SYSTEM WITH INTEGRATED BUSWAY, SMART TAP-OFF BOX AND COMPACT RACK POWER DISTRIBUTION UNITS**

(30) Priority: 04.10.2023 US 202363542422 P; 13.09.2024 US 202418884610
(71) Applicant: Vertiv Corporation, Westerville, OH 43082 (US)
(72) Inventor: WILSON, Brad Lee, Westerville, 43082 (US)
(74) Representative: Bryn-Jacobsen, Caelia

(57) **Abstract**

A high-density power distribution system incorporates smart tap-off boxes (TOB) connected to an overhead busway and receiving therefrom a three-phase input power supply. The smart TOB resolves the three-phase input power into 3N single-phase output power circuits (where N is a positive integer) each connected to an overcurrent protection (OCP) device associated with an amperage level. A set of 3N conductors connected to the smart TOB carries the single-phase output power circuits to a rack power distribution unit (PDU, rPDU) in a server cabinet (e.g., via rack connection devices connecting the conductors to the rPDU), the rPDU including a linear array of output power sockets corresponding to the single-phase output power circuits.

## Description

### CROSS-REFERENCE TO RELATED APPLICATIONS

The present application claims the benefit under 35 U.S.C. § 119(e) of U.S. Provisional Patent Application Serial Number 63/542,422 filed October 4, 2023, titled HIGH DENSITY POWER DISTRIBUTION SYSTEM WITH INTEGRATED BUSWAY, SMART TAP-OFF BOX AND COMPACT RACK POWER DISTRIBUTION UNITS, and naming Brad Wilson as inventor.

### TECHNICAL FIELD

The present disclosure is directed generally to the field of power distribution, and more particularly to devices and components for power distribution.

### BACKGROUND

Due to recent growth in high-density computer-intensive applications and chipsets, many data centers and component cabinets are handling increasingly energy-intensive loads they were never designed to support. Artificial intelligence and/or machine learning (AI/ML) driven direct-to-chip (D2C) liquid cooling workloads may still require significant air cooling, e.g., an average of 20 percent of the total thermal load. The need to maintain air cooling makes rear-rack/rear-cabinet hygiene crucial for maintaining air flow through limited spaces. Further, as power supply sizes increase, outlet counts per circuit will decrease and breaker counts will increase per rack power distribution unit (rPDU). However, physical breaker size hinders rear-rack airflow as well as access to rear-rack components. Further still, conventional C13/C19 outlets may give way to newer, higher-amperage outlets.

### SUMMARY

In a first aspect, a high-density power distribution system is disclosed. In examples, the power distribution system incorporates smart tap-off box (TOB) devices attachable to an overhead busway and receiving therefrom a three-phase input power supply. The smart TOB device resolves the three-phase input power into single-phase output power circuits (e.g., 3N circuits, where N is a positive integer and/or a number of A-phase, B-phase, and C-phase circuits). The smart TOB device also includes overcurrent protector (OCP) devices, each OCP device connected to at least one single-phase output power circuit and each OCP device rated for a particular amperage level. In examples, the power distribution system includes a rack power distribution unit (PDU, rPDU) mountable in the server cabinet and including a linear array of outlet power sockets (e.g., 3N sockets, one for each outlet power circuit). Similarly, a set of 3N conductors (e.g., cables; one conductor for each outlet power circuit) connects the smart TOB device (e.g., by a TOB connecting device) to the rPDU (e.g., via a rack connecting device) provides outlet power to each of the outlet power sockets.

In some examples, the array of outlet power sockets is a vertical stack.

In some examples, the OCP devices include circuit breakers and/or fuses.

In some examples, the OCP devices include a first set of OCP devices rated for a first amperage level and corresponding to a first subset of the 3N outlet power circuits and their corresponding sockets (e.g., 20 A sockets, 30 A sockets); and at least one second set of OCP devices associated with a second amperage level and corresponding to a second subset of the 3N outlet power circuits (e.g., and their corresponding sockets).

In some examples, the set of OCP devices include mixed OCP devices corresponding to a third subset of the 3N outlet power circuits and to their corresponding mixed-amperage sockets, the set of mixed OCP devices including OCP devices associated with the first and the at least one second amperage level.

In some examples, the rack connecting device includes a set of conductors (e.g., corresponding to the 3N single-phase output circuits or to a subset thereof), each conductor terminating in a conductor terminal that plugs into a rack-side connector of the rack connecting device (e.g., and supplies output power to the rPDU via the rack connecting device). For example, the conductor terminals and/or rack-side connectors indicate the conductors by phase and/or amperage level (e.g., low amperage, high amperage, mixed amperage).

In some examples, conductor terminals indicative of or corresponding to a particular amperage level are incompatible with rack-side connectors indicative of or corresponding to other amperage levels.

In some examples, the conductor terminals and/or rack-side connectors indicate association with a particular subset of output power circuits and/or amperage levels according to their shape and/or orientation.

In some examples, the smart TOB includes a monitoring system for collecting power data associated with the three-phase input power supply. Further, the smart TOB includes a communications portal for providing collected power data to a remotely located user, or for receiving control input from the remotely located user.

In some examples, the power data includes an amperage and/or a voltage of the three-phase input power supply.

In some examples, the power data includes an instantaneous power level and/or a cumulative power level of the three-phase input power supply.

In some examples, the power data includes a power factor of the three-phase input power supply.

In some examples, the power data includes circuit power data for one or more monitored single-phase output power circuits based on the input power supply.

In some examples, the circuit power data includes an amperage and/or a voltage of one or more single-phase output power circuits.

In some examples, the circuit power data includes an instantaneous power level and/or a cumulative power level of one or more single-phase output power circuits.

In some examples, the smart TOB monitoring system includes a temperature sensor and/or a humidity sensor.

In some examples, each outlet power socket of the rPDU includes a relay connected to the smart TOB monitoring system. For example, each outlet power socket may be independently activated or deactivated (e.g., based on control input provided by a remote user) via its associated relay.

In some examples, the smart TOB monitoring system includes a monitor display on an external surface or face of the smart TOB, the monitor display capable of presenting collected power data to a user.

In some examples, the plurality of conductors includes one or more meshed conductors, e.g., a subset of conductors disposed within a meshed sleeve.

In some examples, the three-phase input power system includes three-phase delta and/or three-phase Wye power input.

This Summary is provided solely as an introduction to subject matter that is fully described in the Detailed Description and Drawings. The Summary should not be considered to describe essential features nor be used to determine the scope of the Claims. Moreover, it is to be understood that both the foregoing Summary and the following Detailed Description are example and explanatory only and are not necessarily restrictive of the subject matter claimed.

### BRIEF DESCRIPTION OF THE DRAWINGS

The detailed description is described with reference to the accompanying figures. The use of the same reference numbers in different instances in the description and the figures may indicate similar or identical items. Various examples or examples ("examples") of the present disclosure are disclosed in the following detailed description and the accompanying drawings. The drawings are not necessarily to scale. In general, operations of disclosed processes may be performed in an arbitrary order, unless otherwise provided in the claims. In the drawings:
FIG. 1 is a diagrammatic illustration of a legacy power distribution system;
FIG. 2A is an isometric view of a high-density power distribution system according to example of this disclosure;
FIG. 2B is a block diagram illustrating a high-density power distribution system according to examples of this disclosure;
FIG. 3A is a block diagram illustrating additional functionalities of the high-density power distribution system of FIG. 2B;
FIG. 3B is an isometric view of controllable relays for rPDU outlets of the high-density power distribution system of FIG. 2B;
FIG. 4A is a schematic diagram of an exemplary smart tap-off box (TOB) of the high-density power distribution system of FIG. 2B;
FIG. 4B is a profile view, and FIG. 4C is an internal view, of the smart tap-off box of FIG. 4A;
FIGS. 5A and 5B are isometric views of a rack-side connector device and a conductor-side connector of the high-density power distribution system of FIGS. 2A and 2B;
and FIG. 5C is a diagrammatic illustration of connector keying and outlet distribution within variant rPDUs of the high-density power distribution system of FIG. 2B.

### DETAILED DESCRIPTION

Before explaining one or more examples of the disclosure in detail, it is to be understood that the examples are not limited in their application to the details of construction and the arrangement of the components or steps or methodologies set forth in the following description or illustrated in the drawings. In the following detailed description of examples, numerous specific details may be set forth in order to provide a more thorough understanding of the disclosure. However, it will be apparent to one of ordinary skill in the art having the benefit of the instant disclosure that the examples disclosed herein may be practiced without some of these specific details. In other instances, well-known features may not be described in detail to avoid unnecessarily complicating the instant disclosure.

As used herein a letter following a reference numeral is intended to reference an example of the feature or element that may be similar, but not necessarily identical, to a previously described element or feature bearing the same reference numeral (e.g., 1, 1a, 1b). Such shorthand notations are used for purposes of convenience only and should not be construed to limit the disclosure in any way unless expressly stated to the contrary.

Further, unless expressly stated to the contrary, "or" refers to an inclusive or and not to an exclusive or. For example, a condition A or B is satisfied by any one of the following: A is true (or present) and B is false (or not present), A is false (or not present) and B is true (or present), and both A and B are true (or present).

In addition, use of "a" or "an" may be employed to describe elements and components of examples disclosed herein. This is done merely for convenience and "a" and "an" are intended to include "one" or "at least one," and the singular also includes the plural unless it is obvious that it is meant otherwise.

Finally, as used herein any reference to "one example" or "some examples" means that a particular element, feature, structure, or characteristic described in connection with the example is included in at least one example disclosed herein. The appearances of the phrase "in some examples" in various places in the specification are not necessarily all referring to the same example, and examples may include one or more of the features expressly described or inherently present herein, or any combination or sub-combination of two or more such features, along with any other features which may not necessarily be expressly described or inherently present in the instant disclosure.

Broadly speaking, examples of the inventive concepts disclosed herein are directed to a high-density power distribution system incorporating integrated busway and rack power distribution unit (rPDU) components. For example, examples of the power distribution system disclosed herein may more effectively serve the needs of energy-intensive artificial intelligence/machine learning (AI/ML) applications (e.g., large language models (LLM), generative Al) while accommodating next-generation direct-to-chip (D2C) cooling schemes by preserving rear-rack/rear-cabinet hygiene and airspace. "Smart" tap-off boxes (TOB) move overcurrent protection out of the rear-rack space and into the elevated busway space, and compact rPDU implementations allow for next-generation, higher-amperage power outlets while maintaining a compact form factor. Further, the power distribution system is configured for safe implementation and management of higher-amperage and mixed-amperage power supplies and circuits. For example, three-phase input power supplies are resolved above the rackspace by the tap-off box into single-phase output currents, which may incorporate higher amperages and/or mixed amperages relative to conventional three-phase power supplies. The single-phase output circuits may be individually, rather than collectively, routed to the rPDU. Physical power connectors between the TOB and the rPDU may be configured to clearly identify lower-amperage, higher-amperage, and mixed-amperage conductors, preventing inadvertent connection of lower-amperage outlets to higher-amperage OCP devices. The "smart" TOB may provide detailed monitoring of the power supply (e.g., of individual single-phase output circuits as well as the three-phase input supply); power monitoring may be networked to provide comprehensive monitoring data both to facilities managers as well as server managers, eliminating redundant or duplicative monitoring on either end (e.g., TOB-based monitoring vs. rPDU-based monitoring). Further still, overcurrent protection may be monitored and/or adjusted, and individual outlets activated or deactivated, remotely via a "smart" TOB incorporating a monitoring system.

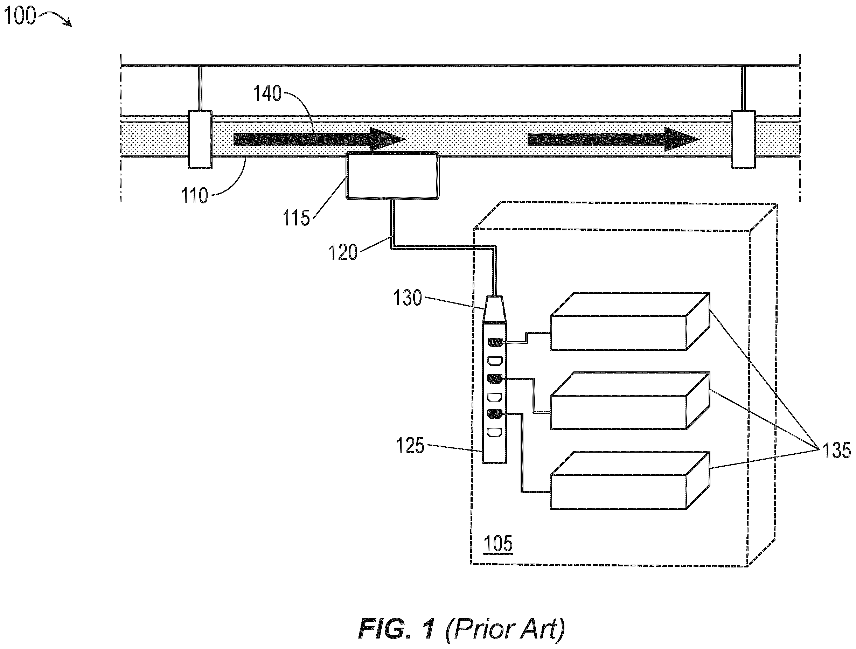

Referring now to FIG. 1, a legacy power distribution system 100 is shown.

In examples, the legacy power distribution system 100 may be similar to those disclosed by U.S. Patent 10,154,610. For example, the legacy power distribution system 100 may include one or more server cabinets 105 (e.g., server racks, not shown) above which (e.g., from a data center ceiling) may be suspended a busway 110. Further, one or more power configuration devices 115 may be attached to the busway 110 and connected, via one or more cables 120, to a power outlet device 125 within the server cabinet 105, the cable connected to the power outlet device via a connector device 130. Server and computer equipment 135 housed within the server cabinet 105 may then be plugged into the power outlet device 125 and may draw operating power therefrom. The busway 110 may enclose a three-phase alternating current (AC) input power supply 140 (e.g., three-phase delta, three-phase Wye). For example, operating power may be provided to server or computer equipment 135 housed within the server cabinet 105 via the power configuration device 115, cable 120, connector device 130, and power outlet device 125.

In examples, power distribution systems as disclosed below may improve upon the legacy power distribution system 100 by incorporating overcurrent protection into a tap-off box (TOB) replacing the legacy power configuration device 115, the TOB likewise attached to the busway 110 and incorporating components connected to the three-phase input power supply 140. For example, the TOB may incorporate overcurrent protection (OCP) devices (e.g., circuit breakers, fuses), eliminating the need for these devices within legacy power outlet devices 125 or within rack power distribution units (rPDU) also disposed within the server cabinet 105. Accordingly, the rPDU may be reduced in volume and/or profile relative to the legacy power outlet device 125. Further, the legacy power configuration device 115 may comprise three-phase OCP devices, such that the cable 120 provides three-phase power input which the power outlet device 125 resolves into single-phase AC circuits. However, the TOB may instead resolve the three-phase input power supply 140 into multiple single-phase power output circuits. Accordingly, the cable 120 would be replaced by a means of individually conveying each of the 3N single-phase outlet circuits from the TOB to the rPDU. For example, as the TOB 205 is resolving three-phase AC input power (140) into single-phase output power circuits, the number of single-phase output power circuits would be a multiple of three, e.g., 9, 12, or 3N for any positive integer N. Further, the legacy connector device 130 may likewise be reconfigured to accommodate 3N appropriately sized conductors/protective earth conductors at each end, e.g., 3N TOB connections at the TOB and 3N rack connections at the rPDU.

In examples, the incorporation of OCP devices within the TOB may eliminate the use of multiple-socket OCP devices as implemented by the legacy power outlet device 125. Further, single-socket OCP devices incorporated within the TOB may allow the use of next-generation socket/outlet implementations at higher amperage ratings. For example, a next-generation AI/ML server may require a 2800 W power supply (e.g., drawing c. 11.66 A at 240 V assuming unity power factor). Conventional OCP devices based on the power outlet device 125 may overload if more than one legacy socket 145 or outlet is used, but higher rated OCP devices (e.g., < 20A) would violate the National Electric Code (similarly, conventional C19 sockets are limited to 16 A by the European Low Voltage Directive).

In examples, the TOB may be configured to accommodate OCP devices rated higher than 20 A. For example, next-generation socket styles manufactured by Anderson Power, BizLink, etc. may be rated for 30A or higher via a relatively small form factor socket (e.g., comparable with C13/C19 legacy sockets 145). Examples of the TOB may combine conventional 20 A OCP devices with 30 A or higher OCP devices, allowing the rPDU to incorporate higher-amperage or mixed-amperage sockets as well as conventional C13/C19 sockets 145.

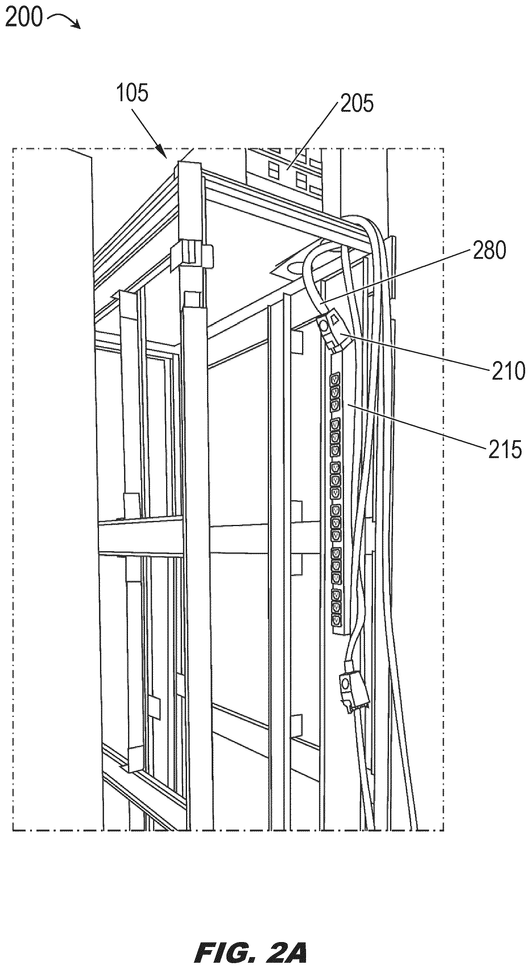

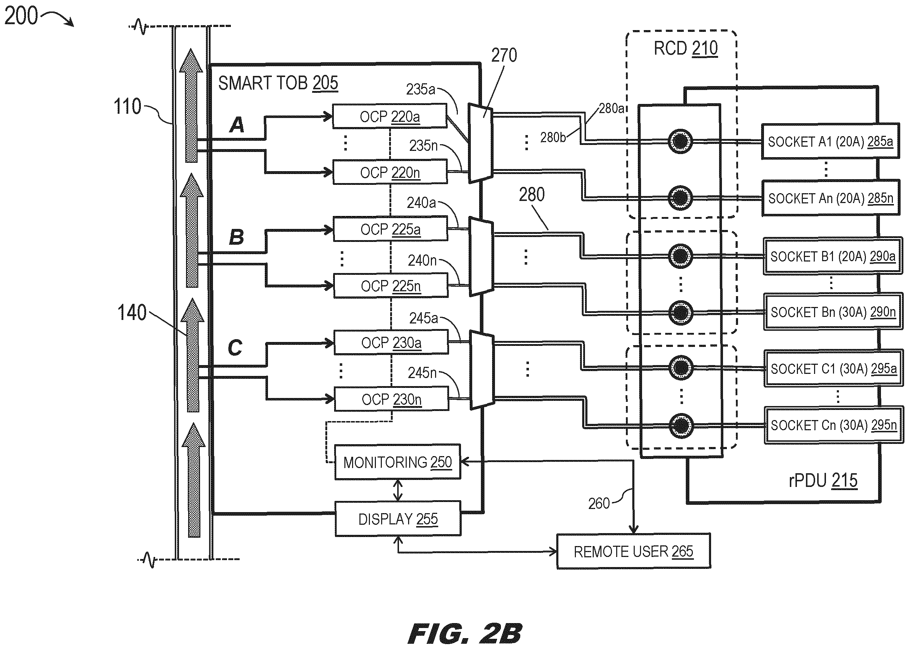

Referring now to FIGS. 2A and 2B, a high-density power distribution system 200 is shown. The high-density power distribution system 200 may include a TOB 205, rack connector device 210 (e.g., connector harness), and rPDU 215.

In examples, the TOB 205 may be attached to the overhead busway (110, FIG. 1) and may draw from the three-phase input power supply (140, FIG. 1; e.g., three-phase delta, three-phase Wye) carried by the busway. For example, the TOB 205 may resolve the three-phase input power supply 140 into a set of 3N single-phase output power circuits (e.g., 6, 9, 12 or some 3N where N is a positive integer). Accordingly, the TOB 205 may include 3N overcurrent protector (OCP) devices 220a-220n, 225a-225n, 230a-230n. For example, N OCP devices 220a-220n may be dedicated to the N single-phase output power circuits 235a-235n based on the first phase, or A phase, of the three-phase input power supply 140; similarly, N OCP devices 225a-225n may be dedicated to the N single-phase output power circuits 240a-240n based on the second or B phase, and N OCP devices 230a-230n may be dedicated to the N single-phase output power circuits 245a-245n based on the third or C phase. In examples, the 3N OCP devices 220a-220n, 225a-225n, 230a-230n may include, in addition to conventional 20 A rated OCP devices, higher-amperage OCP devices. For example, the N A-phase OCP devices 220a-220n may be rated at 20 A while the 2N B-phase and C-phase OCP devices 225a-225n, 230a-230n may be rated at 30 A.

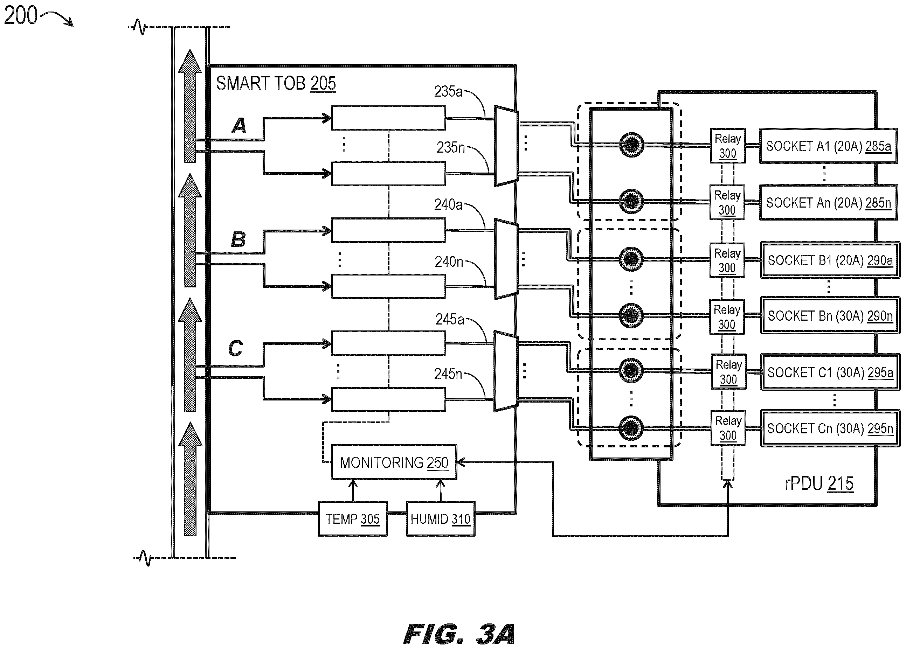

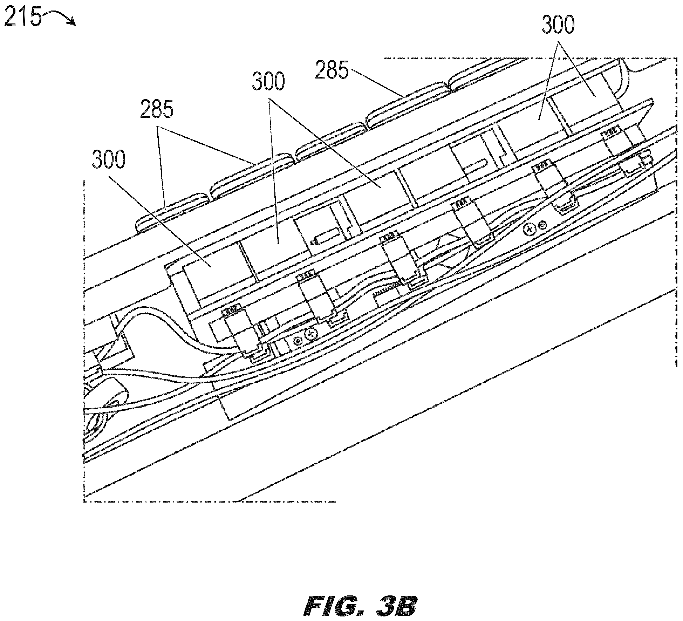

In examples, the TOB 205 may be a "smart" TOB incorporating a monitoring system 250. For example, the monitoring system 250 may determine and report power supply data; e.g., instantaneous or cumulative power consumption by the input power supply 140, as well as instantaneous or cumulative power consumption data by each single-phase power output circuit 235a-235n, 240a-240n, 245a-245n. Further, the monitoring system 250 may track amperage and/or voltage with respect to the input power supply 140 or the single-phase power output circuits 235a-235n, 240a-240n, 245a-245n. Further still, the monitoring system 250 may determine and monitor a power factor (e.g., % of unity) with respect to the input power supply 140 and/or one or more of the single-phase power output circuits 235a-235n, 240a-240n, 245a-245n. In some examples, the monitoring system 250 may include additional monitoring and control functionalities (e.g., as shown by FIGS. 3A and 3B below).

In some examples, the smart TOB 205 may include a display 255 for reporting power consumption data to on-site users. For example, the display 255 may be a touchscreen or interactive display configured to receive control input from an on-site user. In some examples, the monitoring system 250 may include one or more communications ports, links or devices 260 via which the monitoring system may report power consumption data to, and receive control input from, a remote user 265 off-site (e.g., facilities managers, server managers, and/or other personnel located remotely from the server cabinet 105 and/or data center wherein the high-density power distribution system 200 is implemented). For example, the communications ports 260 may include Ethernet or other like wired network connections for reporting power consumption data/receiving control input, and/or wireless network connections to remote users 265.

In examples, the single-phase power output circuits 235a-235n, 240a-240n, 245a-245n may be plugged into the smart TOB 205 via a set of TOB connector devices 270, while the rack connector devices 210 may be hardwired into the rPDU 215. For example, each rack connector device 210 may be implemented as a multi-pin connector including a housing and strain relief. Where a legacy cable (120, FIG. 1) may be implemented via jacketed cabling and three-phase wiring, in examples a set of individually insulated conductors 280 may be configured for routing each single-phase power output circuit 235a-235n, 240a-240n, 245a-245n from the smart TOB 205 (e.g., via the TOB connector device 270) to the rPDU 215 (e.g., via the rack connector device 210). For example, given a set of 3N single-phase output power circuits 235a-235n, 240a-240n, 245a-245n, each single-phase output power circuit may require a conductor (280a) for carrying the output power to the rPDU 215 and a neutral wire (280b) for returning the circuit to the TOB 205; accordingly, a set of 3N single-phase output power circuits may include a total of 6N conductors 280. In examples, the set of conductors 280 may be implemented as one or more meshed conductors, e.g., wherein a set of individually insulated conductors are combined within a meshed sleeve, eliminating the need for significant derating associated with the carriage of the unresolved three-phase input power supply 140.

In examples, the rPDU 215 may maintain a highly compact profile, e.g., approximately 2 inches square with respect to length and width, and may incorporate a set of 3N output power sockets 285a-285n, 290a-290n, 295a-295n (e.g., outlets) arranged in a linear array (e.g., a vertical stack), via which servers and computer equipment (135, FIG. 1) may receive output power. For example, the sockets 285a-285n may connect to the single-phase power output circuits 235a-235n (e.g., associated with the first or A-phase of the input power supply 140), and the sockets 290a-290n, 295a-295n may connect respectively to the single-phase power output circuits 240a-240n, 245a-245n associated with the B and C phases. Accordingly, the sockets 285a-285n may be 20 A-rated sockets, e.g., C13, C19, or hybrid C13/C19 connectors. In some examples, the sockets 285a-285n may include a pair of 20 A-rated sockets coupled to each single-phase power output circuit 235a-235n and to its corresponding 20 A-rated OCP device 220a-220n.

In examples, the sockets 295a-295n may each be implemented as 30 A sockets (e.g., Anderson Saf-D-Grid, BizLink, and any appropriate like 30 A-rated outlet), each 30A socket coupled to a single-phase power output circuit 240a-240n, 245a-245n and to its corresponding OCP device 225a-225n, 230a-230n. Similarly, in examples the sockets 290a-290n may each be implemented as either a 20 A or a 30 A socket, such that the corresponding B-phase single-phase power output circuits 240a-240n may include a combination of 20 A and 30 A circuits, and the corresponding OCP devices 225a-225n include a combination of 20 A-rated and 30 A-rated devices.

Referring now to FIGS. 3A and 3B, the high-density power distribution system 200 and the rPDU 215 are respectively shown.

In examples, the monitoring system 250 within the smart TOB 205 may additionally provide remote control over each of the sockets 285a-285n (290a-290n, 295a-295n) within the rPDU 215. For example, a set of relays 300 may be fitted to each socket (FIG. 3A: 285a-285n, 290a-290n, 295a-295n; FIG. 3B: 285) within the rPDU 215, each relay 300 controllable by the monitoring system 250 to enable or disable power flow through the associated socket. Further, any given socket 285, 285a-285n, 290a-290n, 295a-295n may be remotely disabled via the monitoring system 250, e.g., if power data for the associated single-phase power output circuit 235a-235n, 240a-240n, 245a-245n indicates a potential or actual fault or hazard.

In some examples, the monitoring system 250 may include additional sensors not directly coupled to the three-phase power input supply 140 but configured to provide additional environmental data with respect to the high-density power distribution system 200 generally or, e.g., the rPDU 215 in particular. For example, the monitoring system 250 may include temperature sensors 305, humidity sensors 310, or other like environmental or facility sensors.

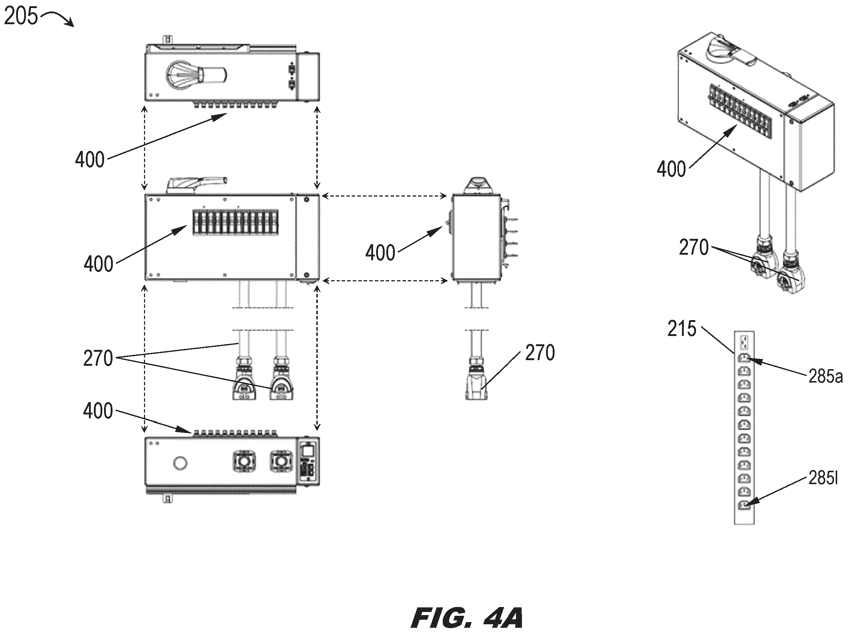

Referring now to FIGS. 4A through 4C, the smart tap-off box (TOB) 205, TOB connector device 270, and/or rPDU 215 are shown.

In examples, the smart TOB 205 may include OCP devices 400. For example, the OCP devices 400 may be implemented and may function similarly to the OCP devices 220a-220n, 225a-225n, 230a-230n shown by FIG. 2A. The set of OCP devices 400 included within the smart TOB 205 may be rated for a single amperage (e.g., 20 A, 30A) or may be rated for multiple or mixed amperages (e.g., a mix of 20 A and 30 A, or other amperages as desired or needed). For example, the TOB 205 may include a set of 12 OCP devices 400, the TOB configured for resolving the three-phase input power supply (140, FIG. 2B) into two sets of three single-phase output power circuits (235a-235n, 240a-240n, 245a-245n, FIG. 2B; wherein N = 2), wherein each single-phase output power circuit incorporates a conductor 280 (FIG. 2B; e.g., a conductor 280a and a neutral 280b).

In examples, the smart TOB 205 may include two TOB connector devices 270. For example, wherein N = 2 as above, each TOB connector device 270 may be dedicated to two sets of three single-phase output power circuits 235a-235n, 240a-240n, 245a-245n, incorporating twelve conductors 280 altogether, e.g., for each of the two sets, three conductors 280a and three neutrals 208b. Further, the rPDU 215 may incorporate twelve sockets 285a-285l (while C13 sockets are shown, the rPDU may incorporate C19 sockets, hybrid sockets, and/or other 20A/30A socket types 290, 295 based on the precise configuration of the corresponding single-phase output power circuits 235a-235n, 240a-240n, 245a-245n).

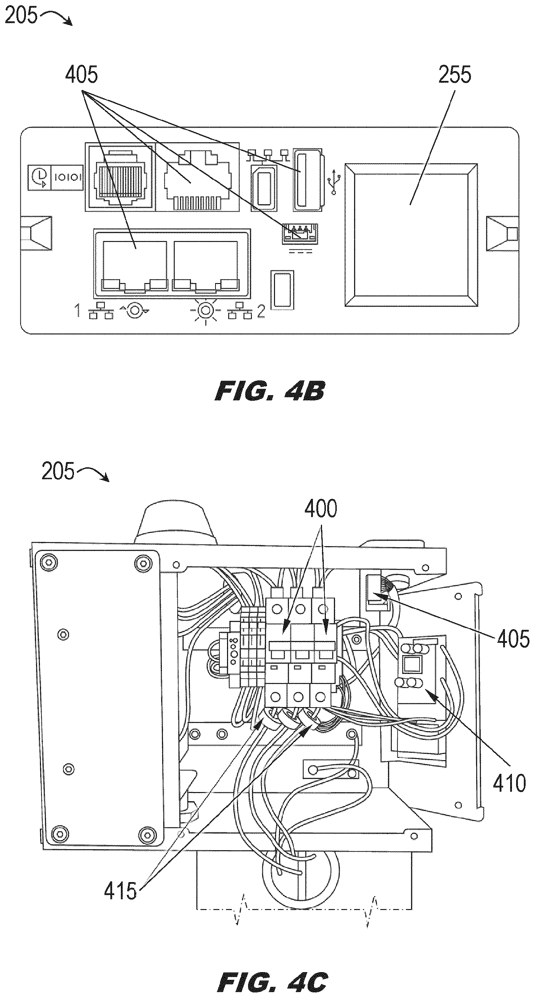

Referring in particular to FIG. 4B, the smart TOB 205 may incorporate a variety of communications ports 405 (e.g., Ethernet, optical, USB, USB-C, HDMI) for use with a variety of networking protocols (e.g., SNMP, TCP/IP, RS232, RS485). Further, the smart TOB 205 may include an external display 255 as described above. It may be noted, however, that the external display 255 may neither be configured (e.g., due to its small size) nor positioned (e.g., within the rear upper rackspace, as best shown by FIG. 2A) for ideal reporting of monitoring data as compared to, e.g., networked transmission or communication of power data to remote users (265, FIG. 2B).

Referring in particular to FIG. 4C, an interior view of the smart TOB 205 is shown as a non-limiting example. For example, the communications ports 405 of the smart TOB 205 may include a network port for connecting the smart TOB to local and/or external networks. Further, the smart TOB 205 may include a monitoring card 410 incorporating voltage touchpoints and/or current sensing components (e.g., current transducers) for voltage/amperage monitoring of the input power supply (140, FIG. 1) and/or single-phase output power circuits 235a-235n, 240a-240n, 245a-245n as discussed above. Further still, the smart TOB 205 may incorporate OCP devices 400 and current transformers 415.

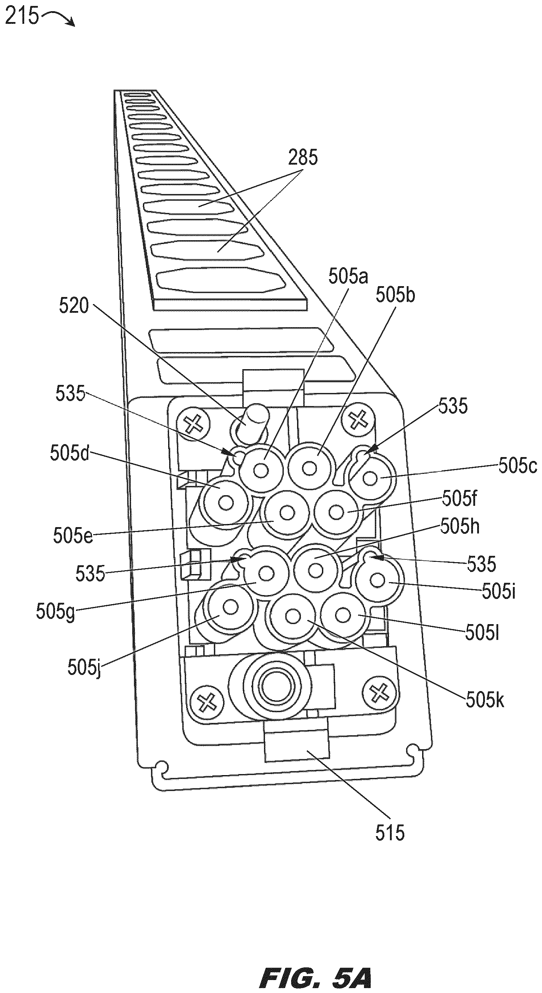

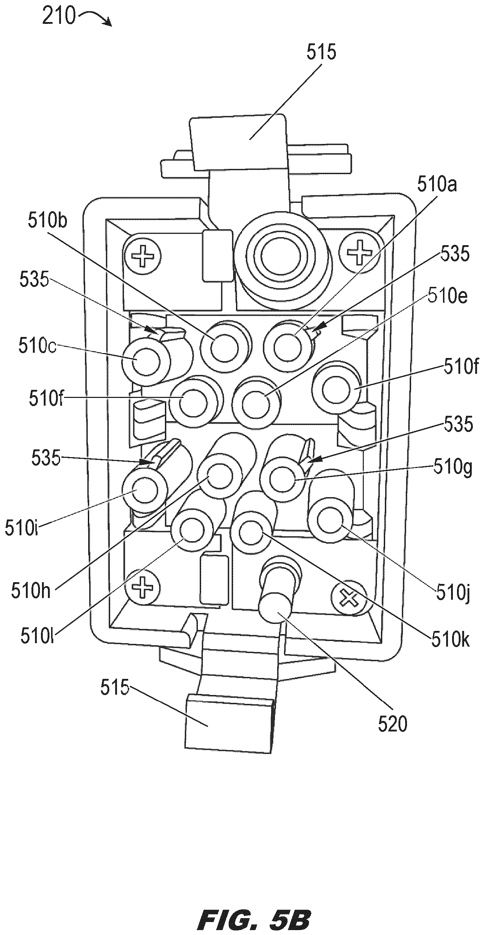

Referring to FIGS. 5A and 5B, the rPDU 215 and rack connector device 210 are respectively shown.

In examples, the rPDU 215 may incorporate a set 500 of rack-side connectors 505a-505l hardwired into the rPDU. For example, the rack-side connectors 505a-505l may be compatible with a set of conductor terminals 510a-510l set into the rack device and serving as the terminal ends of the conductors (280a, FIG. 2A) and neutrals (280b, FIG. 2B) for the two sets of three single-phase output power circuits (235a-235n, 240a-240n, 245a-245n; FIG. 2B). In examples, the conductor terminals 510a-510l may be plugged into or otherwise engaged with the rack-side connectors 505a-505l to supply power (via the single-phase output power circuits 235a-235n, 240a-240n, 245a-245n) to the rPDU 215 (e.g., and to each socket (285a-285n, 290a-290n, 295a-295n; FIGS. 2A-B) of the rPDU). Further, the rack connector device 210 may include tabs 515 and pins 520 compatible with the rPDU 215, the tabs 515 and pins 520 securable to provide additional security and stability for the plugged-in/engaged conductor terminals 510a-510l.

In examples, the rack-side connectors 505a-505l and conductor terminals 510a-510l may be physically keyed to clearly indicate amperage levels (e.g., or other relevant circuit information) for the single-phase output power circuits 235a-235n, 240a-240n, 245a-245n. As noted above, the three-phase input power supply (140, FIG. 2A) may be resolved within the smart TOB (205, FIG. 2B) into single-phase output power circuits 235a-235n, 240a-240n, 245a-245n; these single-phase output power circuits may be, in addition to conventional low-amperage (e.g., 20 A) circuits, high-amperage circuits (e.g., 30 A) or mixed-amperage circuit sets (e.g., a set of three single-phase output power circuits including one or more 20 A circuits and one or more 30 A circuits). In other examples, the three-phase input power supply 140 may be resolved into single-phase output circuits at other amperage levels if desired or needed.

In examples, physical keying of rack-side connectors 505a-505l and conductor terminals 510a-505l may prevent the inadvertent connection to sockets (285a-285n, 290a-290n, 295a-295n) of single-phase output power circuits 235a-235n, 240a-240n, 245a-245n and/or OCP devices (400, FIG. 4A) whose higher amperage levels the sockets may not be configured to handle. For example, eliminating inadvertent connections may therefore significantly reduce the risk of fire or electrical damage to the power distribution system 200 and/or any server or computer equipment (135, FIG. 1) connected or proximate thereto.

In examples, rack-side connectors 505a-505l and conductor terminals 510a-505l may be keyed to indicate an associated amperage level collectively, e.g., with respect to a set of single-phase output power circuits 235a-235n, 240a-240n, 245a-245n and their corresponding OCP devices 400, or individually, e.g., with respect to a particular output power circuit, a particular conductor or set thereof, and a particular OCP device or set thereof. For example, the set of rack-side connectors 505a-505l may be divided into two sets (upper 525, lower 530) of six rack-side connectors, wherein each set 525, 530 includes three rack-side connectors 505a-505c, 505g-505i for carrying a single-phase output power circuit 235a-235n, 240a-240n, 245a-245n and three rack-side connectors 505d-505f, 505j-505l for counterpart neutral cables (280b, FIG. 2B). In examples, the conductor terminals 510a-510c, 510g-510i and 510d-510f, 510j-510l may correspond to the rack-side connectors 505a-505c, 505g-505i and 505d-505f, 505j-505l.

In examples, the rack-side connectors 505a-505c, 505g-505i may be physically keyed to indicate an amperage level of the corresponding set of three single-phase output power circuits 235a-235n, 240a-240n, 245a-245n. For example, as noted above, the set of three single-phase output power circuits associated with each set of rack-side connectors 505a-505c, 505g-505i may be low-amperage (e.g., all 20 A circuits), high-amperage (e.g., all 30 A circuits), mixed-amperage (e.g., mix of 20 A and 30 A circuits). Further, other "low" or "high" amperage levels may be incorporated as desired or needed.

In examples, rack-side connectors 505a-505c, 505g-505i may be keyed to indicate the amperage of their associated single-phase output power circuits based on the shapes of one or more connectors. For example, one or more rack-side connectors 505a, 505c, 505g, 505i may include a tab 535 projecting from the otherwise round connector, while other rack-side connectors 505b, 505d-505f, 505h, 505j-505k are substantially round. In some examples, the use of one or more tabbed rack-side connectors 505a, 505c, 505g, 505i may indicate the associated set of three single-phase output power circuits 235a-235n, 240a-240n, 245a-245n as mixed-amperage or high-amperage. For example, a set of three round rack-side connectors 505b, 505h may indicate a corresponding set of all low-amperage (e.g., 20 A) single-phase output power circuits.

In examples, rack-side connectors 505a-505c, 505g-505i may be additionally or alternatively keyed to indicate the amperage of their associated single-phase output power circuits 235a-235n, 240a-240n, 245a-245n based on the alignment of one or more connectors, particularly connectors incorporating tabs 535. For example, the three single-phase output power circuits associated with the rack-side connectors 505a-505c, 505g-505i may be keyed to indicate mixed-amperage or high-amperage circuits based on the number of tabbed connectors (e.g., one tabbed connector to indicate a mixed-amperage set, two tabbed connectors to indicate a high-amperage set) or via the alignment of each tab 535 relative to its rack-side connector. It may be observed that the tabs 535 of the rack-side connectors 505a, 505g are aligned at a substantially 45-degree angle to the vertical, or between the 10:00 and 11:00 positions, whereas the tabs of the rack-side connectors 505c, 505i are aligned closer to vertical, e.g., nearer the 11:00 position. In examples, the corresponding set of rack-side connectors (e.g., connectors 505a/505g having a tab between 10:00 and 11:00, connectors 505b/505h having no tab, connectors 505c/505i having a tab at 11:00) may be assigned to indicate a specific mixed-amperage or high-amperage set.

In examples, assuming a set of three tabless rack-side connectors (e.g., 505d-505f, 505j-505k, although these connectors are assigned to neutral cables 280b) is keyed to indicate a low-amperage, e.g., all 20 A, set, it may be observed that any tabbed conductor connectors 510a, 510c, 510g, 510i used in whole or in part to indicate a mixed-amperage or high-amperage set of circuits is incompatible with, and cannot be plugged into, a set of tabless rack-side connectors 505d-505f, 505j-505l For example, the use of tabs 535 to indicate higher amperages may prevent the inadvertent insertion of tabbed conductor connectors 510a, 510c, 510g, 510i into tabless rack-side connectors 505d-505f, 505j-505l (and accordingly the inadvertent connection of higher-amperage single-phase output circuits into lower-amperage sockets, as discussed above.)

In some examples, connector keying may be used to indicate amperage level individually, rather than applied to a set of single-phase output power circuits. For example, the presence and/or alignment of tabs 535 relative to a rack-side connector 505a-505l and/or a conductor connector 510a-510l may be used to individually key or indicate the amperage level of the single-phase output power circuit corresponding to a particular combination of rack-side connector and conductor connector. By way of a non-limiting example, the alignment of a single tab 535 may be used to indicate the amperage level of a corresponding single-phase output power circuit, e.g., 1:00 = 5 A, 2:00 = 10 A, etc.

In examples, connector keying of the rack connector device 210 as shown by FIGS. 5A and 5B may likewise be applied by the TOB connector device (270, FIG. 2B).

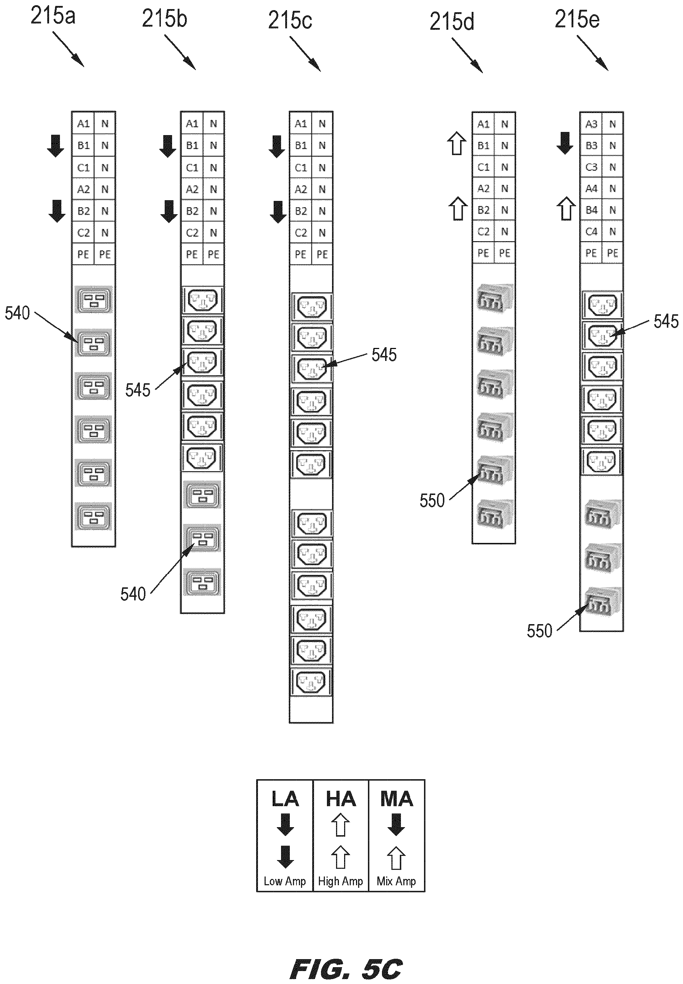

Referring also to FIG. 5C, examples of low-amperage rPDUs 215a-215c, high-amperage rPDU 215d, and mixed-amperage rPDU 215e (and their corresponding sockets 540, 545, 550) are shown.

In examples, the low-amperage rPDU 215a may include six C19 sockets 540, each rated at 20 A. Similarly, the low-amperage rPDU 215b may include six hybrid C13/C19 sockets 545 (e.g., compatible with either C13 or C19 connections) and three C19 sockets 540, each rated at 20 A. Similarly, the low-amperage rPDU 215c may include twelve hybrid C13/C19 sockets 545.

Further, the high-amperage rPDU 215d may include six 30 A sockets 550. Further still, the mixed-amperage rPDU 215e may include six hybrid C13/C19 sockets 545 (rated at 20 A) and three 30 A sockets 550.

### CONCLUSION

It is contemplated that examples of the inventive concepts disclosed herein may have numerous advantages. For example, examples of the power distribution system disclosed herein may more effectively serve the needs of next-generation energy-intensive artificial intelligence/machine learning (AI/ML) applications (e.g., large language models (LLM), generative Al) while similarly accommodating next-generation direct-to-chip (D2C) cooling schemes by preserving rear-rack/rear-cabinet hygiene and airspace. For example, the use of "smart" tap-off boxes moves overcurrent protection out of the rear-rack space and into the elevated busway space. This in turn provides for more compact rPDU implementations capable of incorporating next-generation, higher-amperage power outlets while maintaining a compact form factor. Further, the power distribution system is configured for safe implementation and management of higher-amperage and mixed-amperage power supplies and circuits, resolving three-phase input power above, rather than in, the rackspace and providing for clear identification of conductors by amperage level/s. In this way, inadvertent connection of lower-amperage outlets to higher-amperage OCP devices may be prevented. Further, smart tap-off boxed "smart" TOB may provide detailed monitoring of the power supply, sharing of comprehensive monitoring data across the network to prevent duplicative monitoring, and remote adjustments to overcurrent protection and/or individual outlets (e.g., activation/deactivation).

Those having skill in the art will recognize that the state of the art has progressed to the point where there is little distinction left between hardware and software implementations of aspects of systems; the use of hardware or software is generally (but not always, in that in certain contexts the choice between hardware and software can become significant) a design choice representing cost vs. efficiency tradeoffs. Those having skill in the art will appreciate that there are various vehicles by which processes and/or systems and/or other technologies described herein can be implemented (e.g., hardware, software, and/or firmware), and that the preferred vehicle will vary with the context in which the processes and/or systems and/or other technologies are deployed. For example, if an implementer determines that speed and accuracy are paramount, the implementer may opt for a mainly hardware and/or firmware vehicle; alternatively, if flexibility is paramount, the implementer may opt for a mainly software implementation; or, yet again alternatively, the implementer may opt for some combination of hardware, software, and/or firmware. Hence, there are several possible vehicles by which the processes and/or devices and/or other technologies described herein may be implemented, none of which is inherently superior to the other in that any vehicle to be utilized is a choice dependent upon the context in which the vehicle will be deployed and the specific concerns (e.g., speed, flexibility, or predictability) of the implementer, any of which may vary. Those skilled in the art will recognize that optical aspects of implementations will typically employ optically-oriented hardware, software, and or firmware.

The foregoing detailed description has set forth various examples of the devices and/or processes via the use of block diagrams, flowcharts, and/or examples. Insofar as such block diagrams, flowcharts, and/or examples contain one or more functions and/or operations, it will be understood by those within the art that each function and/or operation within such block diagrams, flowcharts, or examples can be implemented, individually and/or collectively, by a wide range of hardware, software, firmware, or virtually any combination thereof. In one example, several portions of the subject matter described herein may be implemented via Application Specific Integrated Circuits (ASICs), Field Programmable Gate Arrays (FPGAs), digital signal processors (DSPs), or other integrated formats. However, those skilled in the art will recognize that some aspects of the examples disclosed herein, in whole or in part, can be equivalently implemented in integrated circuits, as one or more computer programs running on one or more computers (e.g., as one or more programs running on one or more computer systems), as one or more programs running on one or more processors (e.g., as one or more programs running on one or more microprocessors), as firmware, or as virtually any combination thereof, and that designing the circuitry and/or writing the code for the software and/or firmware would be well within the skill of one of skill in the art in light of this disclosure. In addition, those skilled in the art will appreciate that the mechanisms of the subject matter described herein are capable of being distributed as a program product in a variety of forms, and that an illustrative example of the subject matter described herein applies regardless of the particular type of signal bearing medium used to actually carry out the distribution. Examples of a signal bearing medium include, but are not limited to, the following: a recordable type medium such as a floppy disk, a hard disk drive, a Compact Disc (CD), a Digital Video Disk (DVD), a digital tape, a computer memory, etc.; and a transmission type medium such as a digital and/or an analog communication medium (e.g., a fiber optic cable, a waveguide, a wired communications link, a wireless communication link, etc.).

In a general sense, those skilled in the art will recognize that the various aspects described herein which can be implemented, individually and/or collectively, by a wide range of hardware, software, firmware, or any combination thereof can be viewed as being composed of various types of "electrical circuitry." Consequently, as used herein "electrical circuitry" includes, but is not limited to, electrical circuitry having at least one discrete electrical circuit, electrical circuitry having at least one integrated circuit, electrical circuitry having at least one application specific integrated circuit, electrical circuitry forming a general purpose computing device configured by a computer program (e.g., a general purpose computer configured by a computer program which at least partially carries out processes and/or devices described herein, or a microprocessor configured by a computer program which at least partially carries out processes and/or devices described herein), electrical circuitry forming a memory device (e.g., forms of random access memory), and/or electrical circuitry forming a communications device (e.g., a modem, communications switch, or optical-electrical equipment). Those having skill in the art will recognize that the subject matter described herein may be implemented in an analog or digital fashion or some combination thereof.

Those having skill in the art will recognize that it is common within the art to describe devices and/or processes in the fashion set forth herein, and thereafter use engineering practices to integrate such described devices and/or processes into data processing systems. That is, at least a portion of the devices and/or processes described herein can be integrated into a data processing system via a reasonable amount of experimentation. Those having skill in the art will recognize that a typical data processing system generally includes one or more of a system unit housing, a video display device, a memory such as volatile and non-volatile memory, processors such as microprocessors and digital signal processors, computational entities such as operating systems, drivers, graphical user interfaces, and applications programs, one or more interaction devices, such as a touch pad or screen, and/or control systems including feedback loops and control motors (e.g., feedback for sensing position and/or velocity; control motors for moving and/or adjusting components and/or quantities). A typical data processing system may be implemented utilizing any suitable commercially available components, such as those typically found in data computing/communication and/or network computing/communication systems.

The herein described subject matter sometimes illustrates different components contained within, or connected with, different other components. It is to be understood that such depicted architectures are merely exemplary, and that in fact many other architectures can be implemented which achieve the same functionality. In a conceptual sense, any arrangement of components to achieve the same functionality is effectively "associated" such that the desired functionality is achieved. Hence, any two components herein combined to achieve a particular functionality can be seen as "associated with" each other such that the desired functionality is achieved, irrespective of architectures or intermedial components. Likewise, any two components so associated can also be viewed as being "operably connected", or "operably coupled", to each other to achieve the desired functionality, and any two components capable of being so associated can also be viewed as being "operably couplable", to each other to achieve the desired functionality. Specific examples of operably couplable include but are not limited to physically mateable and/or physically interacting components and/or wirelessly interactable and/or wirelessly interacting components and/or logically interacting and/or logically interactable components.

Further examples are set out in the clauses below:
1. A power distribution system, comprising:
   a tap-off box (TOB) attachable to a busway,
   wherein the busway is configured to provide a three-phase input power supply,
   wherein the TOB configured for resolving the three-phase input power supply into 3N single-phase output circuits, where N is a positive integer, the TOB comprising a plurality of overcurrent protector (OCP) devices, and
   wherein each of the 3N single-phase output circuits is connected to an OCP device, each OCP device associated with an amperage level; a rack power distribution unit (rPDU) mountable in a server cabinet, the rPDU comprising a linear array of 3N output power sockets corresponding to the 3N single-phase output circuits; and
   a set of 3N conductors corresponding to the 3N single-phase output circuits, the set of 3N conductors connected to the TOB by at least one TOB connecting device and to the rPDU by at least one rack connecting device.
2. The power distribution system of Clause 1, wherein the linear array of 3N output power sockets is a vertical stack.
3. The power distribution system of any one of the preceding Clauses, wherein the plurality of OCP devices includes at least one of a circuit breaker or a fuse.
4. The power distribution system of any one of the preceding Clauses, wherein the plurality of OCP devices includes: a set of first OCP devices associated with a first amperage level and corresponding to a first subset of the 3N output power sockets; and at least one set of second OCP devices associated with a second amperage level and corresponding to a second subset of the 3N output power sockets.
5. The power distribution system of Clause 4, wherein the plurality of OCP devices include at least one set of mixed OCP devices corresponding to a third subset of the 3N output power sockets, each set of mixed OCP devices comprising: at least one initial OCP device associated with the first amperage level; and at least one additional OCP device associated with the at least one second amperage level.
6. The power distribution system of Clause 5, wherein the at least one rack connecting device comprises: a plurality of conductor terminals, wherein each of a plurality of conductors corresponding to a subset of the 3N conductors terminates in a conductor terminal; and
   wherein the rPDU comprises a plurality of rack-side connectors, wherein each conductor terminal of the rack connecting device is capable of engaging with a rack-side connector of the rPDU to supply operating power through the conductor to the rPDU via the rack connecting device; and
   wherein at least one of the plurality of conductor terminals or the plurality of rack-side connectors are configured to indicate the plurality of conductors as one of:
      first conductors corresponding to the set of first OCP devices and to the first amperage level; second conductors corresponding to the set of second OCP devices and to a second amperage level of the at least one second amperage level; or
      mixed conductors corresponding to the set of mixed OCP devices.
7. The power distribution system of Clause 6, wherein:
   the plurality of conductor terminals associated with the first conductors are incompatible with the plurality of rack-side connectors associated with the second conductors or the mixed conductors; the plurality of conductor terminals associated with the second conductors are incompatible with the plurality of rack-side connectors associated with the first conductors or the mixed conductors; and
   the plurality of conductor terminals associated with the mixed conductors are incompatible with the plurality of rack-side connectors associated with the first conductors or the second conductors.
8. The power distribution system of Clause 6, wherein the at least one of the plurality of conductor terminals and the plurality of rack-side connectors are configured to indicate the plurality of conductors as at least one of first, second, or mixed according to at least one of: a shape of the conductor terminal or the rack-side connector; or
   an orientation of the conductor terminal or the rack-side connector.
9. The power distribution system of any one of the preceding Clauses, wherein the TOB further comprises:
   a monitoring system configured for determining power data associated with the input power supply; a communications portal configured for at least one of 1) providing to a user power data associated with the input power supply or 2) receiving control input from the user.
10. The power distribution system of Clause 9, wherein the power data associated with the input power supply includes at least one of:
   an amperage of the input power supply; or a voltage of the input power supply.
11. The power distribution system of Clause 9, wherein the power data associated with the input power supply includes at least one of: an instantaneous power level of the input power supply; or a cumulative power level of the input power supply.
12. The power distribution system of Clause 9, wherein the power data associated with the input power supply includes a power factor.
13. The power distribution system of Clause 9, wherein the power data associated with the input power supply includes circuit power data associated with at least one monitored single-phase output power circuit of the 3N single-phase output power circuits.
14. The power distribution system of Clause 13, wherein the circuit power data includes at least one of: an amperage of the monitored single-phase output power circuit; or a voltage of the monitored single-phase output power circuit.
15. The power distribution system of Clause 13, wherein the circuit power data includes at least one of: an instantaneous power level of the monitored single-phase output power circuit; or a cumulative power level of the monitored single-phase output power circuit.
16. The power distribution system of any one of Clauses 9-15, wherein the monitoring system further includes at least one of a temperature sensor or a humidity sensor.
17. The power distribution system of any one of Clauses 9-16, wherein: each output power socket includes at least one relay operatively coupled to the monitoring system; and wherein the monitoring system is configured for at least one of activating or deactivating each output power socket via the at least one relay.
18. The power distribution system of any one of Clauses 9-17, wherein the monitoring system further comprises: at least one monitor display disposed on an external surface of the TOB,
   the monitor display configured to present the power data to a user.
19. The power distribution system of any one of the preceding Clauses, wherein the set of 3N conductors includes one or more meshed conductors, each meshed conductor comprising a subset of the plurality of conductors disposed within a meshed sleeve.
20. The power distribution system of any one of the preceding Clauses, wherein the three-phase input power supply includes one of a three-phase delta power supply and a three-phase Wye power supply.

While particular aspects of the present subject matter described herein have been shown and described, it will be apparent to those skilled in the art that, based upon the teachings herein, changes and modifications may be made without departing from the subject matter described herein and its broader aspects and, therefore, the appended claims are to encompass within their scope all such changes and modifications as are within the scope of the subject matter described herein. Furthermore, it is to be understood that the invention is defined by the appended claims.

## Claims

1. A power distribution system, comprising:
a tap-off box (TOB) attachable to a busway,
wherein the busway is configured to provide a three-phase input power supply,
wherein the TOB configured for resolving the three-phase input power supply into 3N single-phase output circuits, where N is a positive integer, the TOB comprising a plurality of overcurrent protector (OCP) devices,
and
wherein each of the 3N single-phase output circuits is connected to an OCP device, each OCP device associated with an amperage level;
a rack power distribution unit (rPDU) mountable in a server cabinet, the rPDU comprising a linear array of 3N output power sockets corresponding to the 3N single-phase output circuits;
and
a set of 3N conductors corresponding to the 3N single-phase output circuits, the set of 3N conductors connected to the TOB by at least one TOB connecting device and to the rPDU by at least one rack connecting device.

2. The power distribution system of Claim 1, wherein the linear array of 3N output power sockets is a vertical stack; or optionally
wherein the plurality of OCP devices includes at least one of a circuit breaker or a fuse.

3. The power distribution system of any one of the preceding claims, wherein the plurality of OCP devices includes:
a set of first OCP devices associated with a first amperage level and corresponding to a first subset of the 3N output power sockets;
and
at least one set of second OCP devices associated with a second amperage level and corresponding to a second subset of the 3N output power sockets.

4. The power distribution system of Claim 3, wherein the plurality of OCP devices include at least one set of mixed OCP devices corresponding to a third subset of the 3N output power sockets, each set of mixed OCP devices comprising:
at least one initial OCP device associated with the first amperage level;
and
at least one additional OCP device associated with the at least one second amperage level.

5. The power distribution system of Claim 4, wherein the at least one rack connecting device comprises:
a plurality of conductor terminals, wherein each of a plurality of conductors corresponding to a subset of the 3N conductors terminates in a conductor terminal;
and
wherein the rPDU comprises a plurality of rack-side connectors, wherein each conductor terminal of the rack connecting device is capable of engaging with a rack-side connector of the rPDU to supply operating power through the conductor to the rPDU via the rack connecting device;
and
wherein at least one of the plurality of conductor terminals or the plurality of rack-side connectors are configured to indicate the plurality of conductors as one of:
first conductors corresponding to the set of first OCP devices and to the first amperage level;
second conductors corresponding to the set of second OCP devices and to a second amperage level of the at least one second amperage level;
or
mixed conductors corresponding to the set of mixed OCP devices.

6. The power distribution system of Claim 5, wherein:
the plurality of conductor terminals associated with the first conductors are incompatible with the plurality of rack-side connectors associated with the second conductors or the mixed conductors;
the plurality of conductor terminals associated with the second conductors are incompatible with the plurality of rack-side connectors associated with the first conductors or the mixed conductors;
and
the plurality of conductor terminals associated with the mixed conductors are incompatible with the plurality of rack-side connectors associated with the first conductors or the second conductors.

7. The power distribution system of Claim 5, wherein the at least one of the plurality of conductor terminals and the plurality of rack-side connectors are configured to indicate the plurality of conductors as at least one of first, second, or mixed according to at least one of:
a shape of the conductor terminal or the rack-side connector;
or
an orientation of the conductor terminal or the rack-side connector.

8. The power distribution system of any one of the preceding claims, wherein the TOB further comprises:
a monitoring system configured for determining power data associated with the input power supply;
a communications portal configured for at least one of 1) providing to a user power data associated with the input power supply or 2) receiving control input from the user.

9. The power distribution system of Claim 8, wherein the power data associated with the input power supply includes at least one of:
an amperage of the input power supply;
or
a voltage of the input power supply; or optionally
wherein the power data associated with the input power supply includes at least one of:
an instantaneous power level of the input power supply;
or
a cumulative power level of the input power supply; or optionally
wherein the power data associated with the input power supply includes a power factor.

10. The power distribution system of Claim 8, wherein the power data associated with the input power supply includes circuit power data associated with at least one monitored single-phase output power circuit of the 3N single-phase output power circuits.

11. The power distribution system of Claim 10, wherein the circuit power data includes at least one of:
an amperage of the monitored single-phase output power circuit;
or
a voltage of the monitored single-phase output power circuit; and optionally wherein the circuit power data includes at least one of:
an instantaneous power level of the monitored single-phase output power circuit;
or
a cumulative power level of the monitored single-phase output power circuit.

12. The power distribution system of any one of Claims 8-11, wherein the monitoring system further includes at least one of a temperature sensor or a humidity sensor.

13. The power distribution system of any one of Claims 8-12, wherein:
each output power socket includes at least one relay operatively coupled to the monitoring system;
and
wherein the monitoring system is configured for at least one of activating or deactivating each output power socket via the at least one relay.

14. The power distribution system of any one of Claims 8-13, wherein the monitoring system further comprises:
at least one monitor display disposed on an external surface of the TOB, the monitor display configured to present the power data to a user.

15. The power distribution system of any one of the preceding claims, wherein the set of 3N conductors includes one or more meshed conductors, each meshed conductor comprising a subset of the plurality of conductors disposed within a meshed sleeve; or optionally
wherein the three-phase input power supply includes one of a three-phase delta power supply and a three-phase Wye power supply.
